Europäisches Patentamt

European Patent Office

Office européen des brevets

(19)

(11) **EP 0 930 715 A2**

(12) **EUROPEAN PATENT APPLICATION**

(43) Date of publication:
**21.07.1999 Bulletin 1999/29**

(51) Int Cl.$^6$: **H03M 1/10**
// H03M1/44

(21) Application number: **99300237.7**

(22) Date of filing: **14.01.1999**

(84) Designated Contracting States:
**AT BE CH CY DE DK ES FI FR GB GR IE IT LI LU MC NL PT SE**
Designated Extension States:
**AL LT LV MK RO SI**

(30) Priority: **15.01.1998 US 1563 P**

(71) Applicant: **Texas Instruments Incorporated**
**Dallas, Texas 75251 (US)**

(72) Inventor: **Nagaraj, Krishnaswamy**
**Sommerville, New Jersey 08876 (US)**

(74) Representative: **Holt, Michael**
**Texas Instruments Limited,**
**P.O. Box 5069**
**Northampton NN4 7ZE (GB)**

(54) **Digital self-calibration scheme for a pipelined a/d converter**

(57) A digital self calibration scheme for pipelined AD converters. The scheme can correct for capacitor mismatch, capacitor non-linearity, amplifier gain and amplifier nonlinearity.

FIG. 6

EP 0 930 715 A2

**Description**

Field of the Invention

The present invention relates to digital self-calibration schemes for pipelined A/D converters.

Background of the Invention

Analog to digital conversion is the process of converting an analog data signal, which is most commonly represented as voltage, into a digital format. Determining a digital value which represents a particular analog input is known as "quantization". Serial, delta-sigma or over-sampling, parallel, and pipelined are some of the many different analog to digital conversion architectures which exist. Different architectures are suited to different needs.

Serial analog to digital architecture offers the widest range of performance in analog to digital conversion, from low power and low resolution to quantizations with very high resolutions. Serial architecture quantizes analog data at the rate of one bit per cycle. Therefore, a digital sample having $N$ bits of resolution will take $N$ cycles to fully quantize. Delta-sigma analog to digital architecture is used in audio signal processing. The architecture is designed to translate high-speed, low-resolution samples into higher-resolution, lower-speed output. This process is also referred to as oversampling because more samples of the analog data are quantized than actually become output. Parallel analog to digital architecture provides the fastest quantization rate per analog signal. In the parallel architecture, a digital value per cycle is produced for each analog data sample, without regard to $N$, the number of bits of resolution. Parallel architecture requires that all quantization levels be simultaneously compared to the analog signal. This results in the use of $2N-1$ comparators and $2N+1$ resistors to achieve a digital value, with $N$ bits of resolution, per cycle.

Pipelined analog to digital architecture, like serial analog to digital architecture, is a method of quantizing an analog signal in stages. Algorithms exist for obtaining either 1 or 1.5 bits of resolution per stage. In a 1.5-bit per stage converter, the digital output of each stage is either 1, 0, or -1. In a 1-bit per stage converter, the digital output of each stage is either 1 or -1. For either algorithm, $N$ stages are required for an $N$-bit digital value. One bit is resolved at each stage with the result and analog signal sample passed along to the next stage for resolution of another bit. Producing a single digital value for a single analog input requires $N$ cycles, one for each stage. However, the pipelining permits a high degree of parallelism, so that one output per cycle can be produced after the pipeline fills up.

Pipelined analog to digital converters have many applications. They are particularly useful when low voltage, high speed, high resolution quantization is required. The pipelined analog to digital conversion architecture's ability to meet these demands makes it ideal for high volume telecommunications application such as various digital subscriber lines, digital signal processing at video rates, and for stand alone high speed analog to digital converters.

The advantage of pipelined analog to digital conversion is that each stage of resolution is separated. Once the analog signal is resolved at the first stage and the result passed to the second stage, a new signal can be processed by the first stage. The passing of result and signal from stage to stage continues to stage N at which point a digital value of $N$ bits of resolution can be produced. Quantization of the first signal to $N$ bits of resolution is achieved in $N$ cycles. However, because each stage resolves one bit and passes the result to the next stage, the former stage is free to resolve a bit of the next analog sample.

This staged design allows $N$ analog samples to be in the process of quantization simultaneously. Once the first analog sample is quantized, after $N$ cycles, each successive analog sample is quantized one cycle later. Thus, there is only one cycle delay per digitized signal after the first is fully quantized. Pipelined analog to digital conversion therefore results in the fastest throughput rate of any analog to digital conversion that quantizes one-bit per conversion cycle, as it is capable, after an $N-1$ cycles start up period, of quantizing one sample per cycle.

Errors can be introduced into the conversion process at different stages and by different components. Two of the most common components in analog to digital conversion which can cause error are capacitors and amplifiers. Capacitors can introduce error because of a mismatch concerning the capacitance ratio of two capacitors or due to a capacitor's non-linearity over a given voltage range. Amplifiers can introduce error by way of gain error, that is, a fixed difference of output versus input. Amplifiers can also introduce error through non-linearity. Non-linearity is characterized by a change in the amplifier's gain as the output gets higher. Non-linearity can be depicted graphically as the deviation from a straight line from the plot of output versus input.

A digital self-calibration technique for pipelined analog to digital converters which corrects for capacitor mismatch has been disclosed in Hae-Seung Lee, A 12-B 600 KS/S DIGITALLY SELF-CALIBRATED PIPELINED ALGORITHMIC ADC, IEEE Journal of Solid State Circuits, Vol 29, No. 4, Apr. 1994, at 509, which is incorporated herein by reference. This article demonstrates the necessary steps for determining the mismatch ratio of two nominally equal capacitors. The difference of the capacitance between two nominally equal capacitors, $C_1$ and $C_2$, can be represented as $C_1=(1+x_i)C_2$ where $x_i$ represents the mismatch ratio in capacitance between capacitors $C_1$ and $C_2$. Once $x_i$ is known, the error due to capacitance mismatch can be canceled by adding a digital correction quantity:

$$\frac{\alpha_i}{2_i}[(D(i)/2^i - D(i+1)/2^{i+1} - D(i+2)/2^{i+2} - ...]$$

to the digital output, where D(i) represents the digital output of the ith stage of a pipelined analog to digital converter.

In the Lee article, several assumptions are made concerning the need for digital self-calibration and the extent to which error should be corrected. The article assumed that the only linearity error present in a 1.5 bits per stage converter is caused by capacitor mismatch. This assumption was based on the presence of an operational amplifier at each stage of the pipeline with "high enough" gain to effectively eliminate the amplifier gain and non-linearity. In other words, the article assumes an amplifier with infinite gain. However, such an amplifier is merely theoretical. Further, an amplifier with a "high enough" gain is costly to produce (especially in low voltage designs) in terms of monetary cost, power consumption and area requirement. Requiring such an operational amplifier for each stage of the pipeline would increase the cost of the converter significantly. Further, higher bit resolutions will require amplifiers with higher gain. Higher gain creates a larger output swing which can cause slew rate and phase margin degradation.

If the gain error of an amplifier is fixed, it can then be corrected in a fashion similar to the capacitor error correction technique described by Lee. This would require designing an amplifier with constant gain over its entire input signal range. This would allow an error correction constant to be applied to the digital output of the pipelined analog to digital converter to correct for amplifier gain errors. However, such an amplifier design is difficult and costly to implement. For example, an amplifier with a 60dB raw gain would have to have a constant gain within 10% across the entire signal range in order for a single amplifier gain correction constant to be used with a 14-bit analog to digital conversion.

Correction schemes in the analog domain have been described by Hester, Tan, et al. in various issues of the IEEE Journal of Solid-State Circuits, cited below. Such analog calibration schemes generally require a calibration digital-to-analog converter for each stage. Such a configuration increases the complexity, cost, and size of the converter and the capacitive loading on the operation amplifier. The capacitor arrays generally used to implement such schemes also have the effect of slowing down the circuit's response time.

A digital self-calibration technique for correction of capacitor mismatch errors in pipelined analog to digital converters is known. However, a similar method for correction of amplifier errors is not. Further, a method which combines both capacitor and amplifier error correction into a digital self-calibration technique is not known.

Summary of the Present Invention

The present application discloses a digital self-calibration method for pipelined analog to digital converters which demonstrates that the errors introduced by capacitor mismatch, capacitor non-linearity, amplifier gain, and amplifier non-linearity can be effectively eliminated at the same time. This elimination of error takes place at conversion of the analog signal such that the output of the analog to digital conversion process is a corrected and highly accurate digital representation.

An advantage of the disclosure is that four major sources of error in analog to digital conversion are accounted for and corrected at one time. This allows for faster and more accurate digital representations of analog data. Another advantage of the present disclosure is that once error values are established for the converter, the calibration scheme needs no outside data to eliminate the error. Another advantage of the present disclosure is that the self-calibration of each stage can be performed without having to calibrate the other stages, this eliminates accumulation of errors in the correction terms. Another advantage of the present disclosure is that the self-calibration can be scaled to account more or fewer bits of precision in the digital output.

Brief Description of the Drawings

The present invention will now be further described, by way of example, with reference to the accompanying drawings, which show important exemplary embodiments of the invention wherein:

Figure 1 illustrates the circuit of Figure 4 configured to calculate gain error at various segments of an input voltage range V(i);
Figure 2A represents the voltage input range V(i) applied to the ith stage of a pipelined analog to digital converter;
Figure 2B represents the amplifier gain for an operational amplifier in the ith stage a pipelined analog to digital converter over the input voltage range V(i);
Figure 3 graphically represents a digital calibration strategy for correcting amplifier gain and non-linearity;
Figure 4 illustrates the ith stage of a conventional 1.5 bits per stage pipelined analog to digital converter;
Figure 5 illustrates an alternative method for calculating amplifier gain;

Figure 6 represents the preferred implementation method of the digital self-calibration technique; and
Figure 7 schematically depicts a 1.5 bits per stage pipelined analog to digital converter.

Detailed Description of the Preferred Embodiments

The numerous innovative teachings of the present application will be described with particular reference to the presently preferred embodiment. However, it should be understood that this class of embodiments provides only a few examples of the many advantageous uses of the innovative teachings herein. Moreover, some statements may apply to some inventive features but not to others.

Calibrating for amplifier gain and non-linearity error can be achieved by taking the variable gain variation of the amplifier into account in digitally correcting the signal. This is a far less costly way of calibration when compared to designing an amplifier with constant gain over its entire input signal range.

The digital self-calibration scheme accomplishes error correction by subtracting the total error resulting from capacitor mismatch and non-linearity and amplifier gain and non-linearity which can occur in each stage of the pipeline. As demonstrated by Lee above, capacitor mismatch can be measured for each stage of the pipeline by determining the mismatch ratio for the nominally equal capacitors, $C_1$ and $C_2$ in each stage, $i$, of the pipeline. This mismatch ratio is represented as $x_i$.

As described below, amplifier gain and non-linearity can be measured by digitally sampling the gain of the amplifier in each stage of the pipeline. Using a resistor network, the gain is sampled over a number of segments which cover the entire input range of the amplifier. The input voltage is subtracted from the digital sample to produce $A_i$, the gain error for a given stage, $i$, of the pipeline. The total error, for both capacitor mismatch and non-linearity and amplifier gain and non-linearity, for the ith stage of the pipeline is represented as:

$$V_{err}(i) = \left(\alpha_i - \frac{4}{A_i}\right)V_{in}(i) - \left(\alpha_i - \frac{2}{A_i}\right)D_i V_R$$

The error terms can be reduced to:

$$V_{err}(i) = \beta_i V_{in}(i) - \gamma_i D_i V_R$$

$\beta_i$ and $\gamma_i$ are calculated for each stage, $i$, of the pipeline. These values are stored in a memory array.

Once the pipeline produces a digital result, the error values associated with the result can be referenced from the array. The error for each stage of the pipeline is then totaled and subtracted from the digital result of the pipeline to produce a corrected digital output.

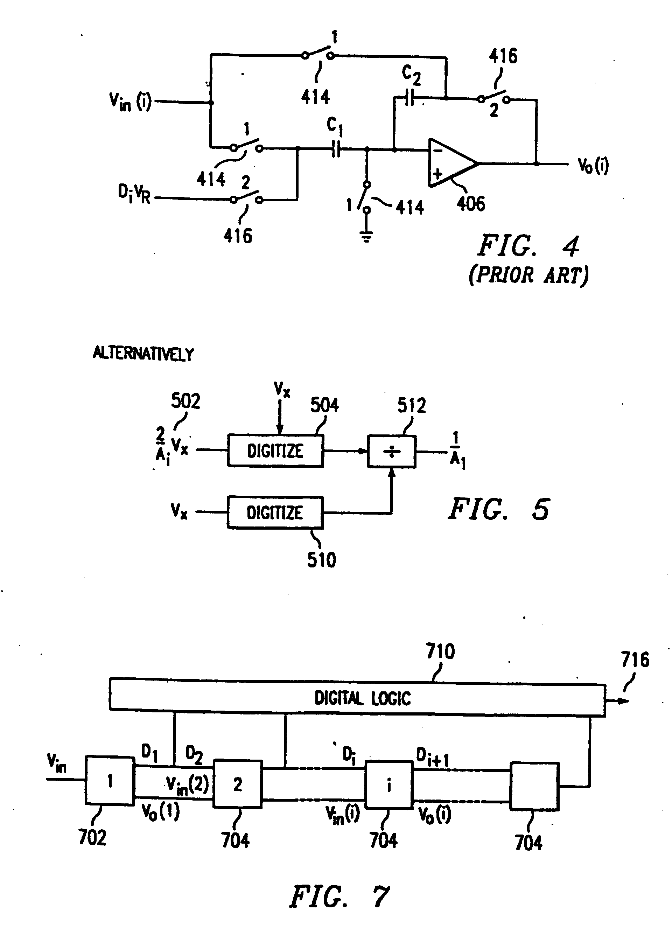

Figure 4 illustrates the ith stage of a conventional 1.5 bits per stage pipelined analog to digital converter. Each stage of a pipelined analog to digital converter consists of two nominally equal capacitors, $C_1$ and $C_2$, and an operational amplifier 406.

The ith stage operates in two phases. $V_{in}(i)$ is the input voltage as to stage $i$. $V_R$ represents the reference voltage sample that is being quantized in the pipelined analog to digital converter. In the first phase, $V_{in}(i)$ is compared with two levels, $V_+ (0 < V_+ < V_R/2)$ and $V_- (-V_R/2 < V_- < 0)$. Digital output $D(i)$ is produced according to:

$$D(i) = \begin{array}{l} = 1 \ \ if \ \ V_{in}(i) > V_+ \\ = 0 \ \ if \ \ V_- < V_{in}(i) < V_+ \\ = \_1 \ \ if \ \ V_{in}(i) < -V_- \end{array}$$

In the second phase, $V_o(i)$, the voltage output of stage $i$ which is to be passed as $V_{in}(i + 1)$ to stage $i + 1$ is produced. $V_o(i)$ is represented as $2V_{in}(i) - D(i)V_R$.

The circuit comprising the ith stage is designed with switched capacitor architecture, although a dc loop or other design could be used. In the first phase, switches 414 are turned "ON" and switches 416 are turned "OFF", connecting the operational amplifier 406 in unity gain mode. This allows sampling of the voltage $V_{in}(i)$ on capacitors $C_1$ and $C_2$. In the second phase, switches 414 are turned "OFF" and switches 416 are turned "ON". Igx noring charge rejection, $V_o(i)$ is represented as $2V_{in}(i) - D(i)V_R$.

When capacitor mismatch and amplifier gain error are taken into consideration, $V_o(i)$ is represented as

$$V_o(i) = 2\left(1 - \frac{2}{A_I}\right)\left(1 + \frac{\alpha_i}{2}\right)V_{in}(i) - \left(1 - \frac{2}{A_I}\right)(1 + \alpha_I)D_I V_R$$

where amplifier gain is represented as $A_i$. The error of $V_o(i)$ can then be represented as:

$$V_{err}(i) = \left(\alpha_i - \frac{4}{A_i}\right)V_{in}(i) - \left(\alpha_i - \frac{2}{A_i}\right)D_i V_R$$

If we define

$$\beta_i = \left(\alpha_i - \frac{4}{A_i}\right)$$

and

$$\gamma_i = \left(\alpha_i - \frac{2}{A_i}\right)$$

then $V_{err}(i)$ can be represented as

$$V_{err}(i) = \beta_i V_{in}(i) - \gamma_i D_i V_R$$

The error in $V_o(i)$ can be approximated digitally by:

$$DV_{err}(i) = \beta_i DV_{in}(i) - \gamma_i D_i$$
$$= \beta_i\left(\frac{D_i}{2} + \frac{D_{i+1}}{2^2} + \frac{D_{i+2}}{2^3} + ....\right) - \gamma_i D_i$$

where $DV_{in}(i)$ is a digital approximation of $V_{in}(i)$. The digital approximation of the error eliminates $V_R$ as it is a normalizing factor. While this calculation includes error, in that it is only a digital approximation, it is assumed to be a perfect digital representation of $V_{in}(i)$ for the purposes of calculating $DV_{err}(i)$. The digital approximation of $V_{in}(i)$ is calculated using the digital results of successive stages of the pipelined analog to digital converter.

Figure 7 schematically depicts a 1.5 bits per stage pipelined analog to digital converter. Each stage 702 and 704 resolves one bit of the digital approximation of $V_{in}$. The first stage 702 accepts the sampled voltage, $V_{in}$, as input

and produces a digital output of 1-bit and an output voltage, $V_o(1)$. $V_o(1)$ becomes $V_{in}(2)$ for the next stage 704 of the converter. The digital output, $D_1$, becomes the digital input $D_2$ for the next stage of the converter 704. The digital output of each stage is also input to the digital logic unit 710 for output of the self-calibrated digital approximation of the input voltage 716. The second and successive stages of the converter accept as input both $V_{in}(i)$ and $D_i$ and have as their output $V_o(i)$ for the next stage and $D_i$ for the digital logic unit and the next stage, $i + 1$. The last stage of the pipelined converter has only $D_i$ as its output as a $V_o(i)$ is not necessary.

The error introduced in each stage of the pipelined analog to digital converter can be numbered starting with the most significant bit stage. This yields the following input referred error terms:

$$DV_{err}(1) = \beta_1 \left( \frac{D_1}{2} + \frac{D_2}{2^2} + \frac{D_3}{2^3} + ... \right) - \gamma_1 D_1$$

$$DV_{err}(2) = \frac{\beta_2}{2} \left( \frac{D_2}{2} + \frac{D_3}{2^2} + \frac{D_4}{2^2} + ... \right) - \gamma_2 D_2$$

$$DV_{err}(3) = \frac{\beta_3}{2^2} \left( \frac{D_3}{2} + \frac{D_4}{2^2} + \frac{D_5}{2^2} + ... \right) - \gamma_3 D_3$$

Alternatively, we can define error for each bit of the conversion, again numbering from the most significant bit stage, as:

$$err(D_1) = \left( \frac{\beta_1}{2} - \gamma_1 \right)$$

$$err(D_2) = \left( \frac{\beta_1 + \beta_2}{2^2} - \frac{\gamma_2}{2} \right)$$

$$err(D_3) = \left( \frac{\beta_1 + \beta_2 + \beta_3}{2^3} - \frac{\gamma_3}{2^2} \right)$$

$$err(D_k) = \left( \frac{\beta_1 + \beta_2 + \beta_3 + ... \beta_k}{s^k} - \frac{\gamma_k}{2^{k-1}} \right)$$

The total error for the output of the analog to digital converter is represented by:

$$TOTAL\ ERROR = D_1 err(D_1) + D_2 err(D_2) + D_3 err(D_3)...$$

Therefore, by digitally subtracting this error, we can cancel the error due to capacitor mismatch and amplifier gain and non-linearity.

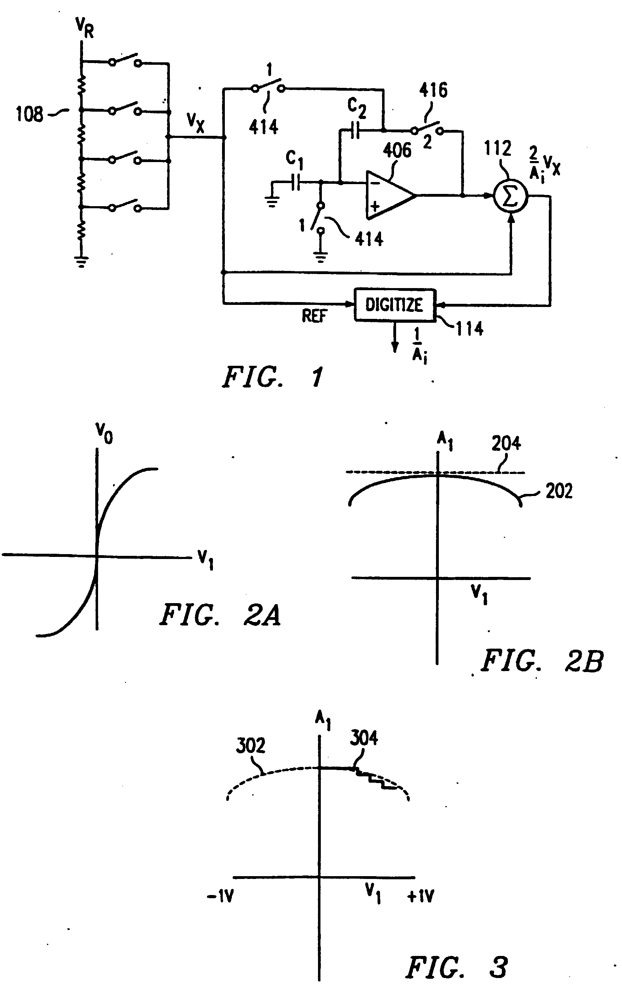

Unlike digital errors due to capacitor mismatch, errors introduced by amplifiers are not constant across the input range for a given amplifier. The values of $\beta_i$ and $\gamma_i$ as described above are dependent on $V_o(i)$, the input signal at stage $i$. Figure 2A represents the voltage input range $V(i)$ applied to the $i$th stage of a pipelined analog to digital converter. In Figure 2B, the solid line 202 represents amplifier gain $A_i$ for an operational amplifier 416 in the ith stage of the same pipelined analog to digital converter over the given input voltage range $V(i)$. The dashed line 204 represents the output of a theoretical operational amplifier with constant gain over the same voltage input $V(i)$.

Figure 3 graphically represents a digital calibration strategy for correcting amplifier gain and non-linearity. In Figure 3, the amplifier's gain $A_i$ over the input voltage $V(i)$ is represented as a dashed line 302. The solid line 304 defines a digital approximation of the amplifier's gain. The precision of this piecewise linear approximation increases with the number of segments sampled at each stage. A sample of 4 segments provides for adequate precision in a 14-bit conversion. Two bits of resolution provides for four segments of piecewise approximation of the amplifier's gain over $V(i)$, the range that will be the input to the $i$th stage of a pipelined analog to digital converter. This piecewise strategy is followed for each stage of the pipelined analog to digital converter as each stage has a separate operational amplifier with separate gain and linearity characteristics.

Figure 1 illustrates the circuit of Figure 4 configured to measure gain error at various segments of an input voltage range $V(i)$. Voltage $V_x$ is representative of a possible input voltage for a particular segment of the $i$th stage amplifier. The resistor network 108, is representative of the manner in which an input reference voltage, $V_R$, is divided into the number of segments desired for gain error measurement.

The measurement is produced in two phases. In phase one, switches 414 are turned "ON" and switches 416 are turned "OFF", connecting the operational amplifier 416 in unity gain mode. This allows sampling of $V_x$ on capacitors $C_1$ and $C_2$. In phase two, switches 414 are turned "OFF" and switches 416 are turned "ON". The produces voltage $V_x$ plus any gain error introduced by the operational amplifier function. This amplifier output is summed 112 with the original voltage $V_x$ yielding, $2V_x/A_i$ or, two times the voltage modified by any amplifier gain error. This result is digitized 114 using voltage $V_x$ as a reference. Therefore $V_x$ is cancelled, yielding the amplifier gain error for the given segment, represented as $1/A_i$. This process is repeated for each segment, utilizing the resistor network 108 to introduce a voltage $V_x$ representative of a voltage within the segment. The entire process is repeated for each stage of the pipelined analog to digital conversion.

Alternatively, as represented by Figure 5, once the input voltage $V_x$ has been multiplied by two and modified by any operational amplifier gain error 502, the result can be digitized 504 with the original $V_x$ subtracted out yielding $V_x/A_i$. In a separate phase, the input voltage $V_x$ can be digitized 510. $V_x$ can then be divided 512 out of $V_x/A_i$ yielding $1/A_i$ 514, the amplifier gain error for the given segment.

Using either method, once $1/A_i$ is known, the values $\beta_i$ and $\gamma_i$ can be calculated not only for a particular stage, $i$, of the pipelined analog to digital converter but also for segments within each stage according to:

$$err(D_1) = \left( \frac{\beta_1}{2} - \gamma_1 \right)$$

$$err(D_2) = \left( \frac{\beta_1 + \beta_2}{2} - \frac{\gamma_2}{2} \right)$$

$$err(D_3) = \left( \frac{\beta_1 + \beta_2 + \beta_3}{2^2} - \frac{\gamma_3}{2^2} \right)$$

$$err(D_k) = \left( \frac{\beta_1 + \beta_2 + \beta_3 + \dots \beta_k}{s^k} - \frac{\gamma_k}{2^{k-1}} \right)$$

The values for each segment in a stage can be represented as $\beta_{ij}$ and $\gamma_{ij}$ where $i$ represents the current stage of the pipelined analog to digital converter and $j$ represents the amplifier gain segment within the ith stage.

Such a piecewise approximation of amplifier gain error, while possible, is not necessary for each stage of the

7

pipelined analog to digital converter. Typically, for amplifier non-linearity correction, only the first three stages, counting from the most significant bit stage, need to be corrected by segments. Further, for 14-bit precision, only around 6 stages of the pipelined analog to digital converter need be corrected for amplifier non-linearity at all. Of those six stages, only the first three need to rely on the piecewise approximation method of amplifier error correction. Stages four through six can rely on a fixed correction -for each amplifier gain stage without having to perform further segmented gain correction. This correction value can be calculated as described with the piecewise approximation gain correction but requires only one measurement of the amplifier gain.

Therefore, the calibration for amplifier non-linearity can be represented by:

$$err(D_1) = \frac{\beta_1}{2} - \gamma_1 D_1$$

$$err(D_2) = \frac{\beta_1 + \beta_2}{2^2} - \frac{\gamma_2}{2}$$

$$err(D_3) = \frac{\beta_1 + \beta_2 + \beta_3}{2^3} - \frac{\gamma_3}{2_2}$$

$$err(D_4) = \frac{\beta_1 + \beta_2 + \beta_3}{2^4} + \frac{\beta_4}{2^4} - \frac{\gamma_4}{2^3}$$

$$= \frac{\beta_1 + \beta_2 + \beta_3}{2^4} + ferr(D_4)$$

Where k>4,

$$err(D_k) = \frac{\beta_1 + \beta_2 + \beta_3}{2^k} + ferr(D_k)$$

with

$$ferr(D_k) = \frac{\beta_k}{2^k} - \frac{\gamma_k}{2^{k-1}} + ferr(D_{k-1})$$

*ferr* represents a fixed error for each stage used to calibrate the converter.

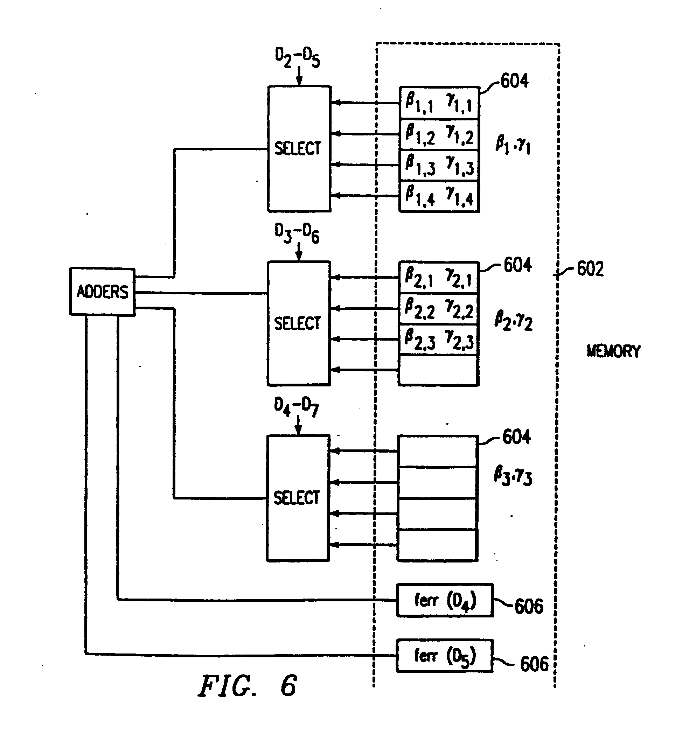

Figure 6 represents the preferred implementation method of the digital self-calibration scheme. The values for $\beta_{ij}$ and $\gamma_{ij}$ where $i=1$ to the number of stages of the pipelined analog to digital converter that are to be calibrated through piecewise approximation and $j=1$ to the number of segments of amplifier gain approximation desired per stage, are stored in non-volatile memory 602 as they are calculated. For each $i$, the corresponding $j$ values are stored in a two-dimensional array 604 containing both $\beta$ and $\gamma$ values. For pipelined stages beyond $i$ but still within the stages that are to be corrected for amplifier non-linearity, approximately 6 for a 14-bit resolution converter, a single correction factor 606 is calculated and stored.

To apply the proper $\beta_i$ and $\gamma_i$, the digital output of stages $I + 1$ to $I + x$, where $x =$ the number of bits of precision used in the piecewise approximation amplifier gain correction calculation, is used to reference the proper row of the matrix corresponding to $\beta_i$ and $\gamma_i$. E.g., if eight segments were used, $x$ would need to be three, $(2^3 = 8)$ and if $i = 1$; $D_2 = 1$; $D_3 = 0$; and $D_4 = 0$, the values of $\beta_{1,4}$ and $\gamma_{1,4}$ would be substituted in the error correcting equations for $\beta_1$ and $\gamma_1$

The same process would be followed for the successive stages of the converter which are to be corrected through the piecewise approximation method, i.e. for i = 2, $D_{3-5}$ would be used to reference the error correction values, etc. For stages beyond piecewise approximation error correction, a single memory element is referenced, e.g., *ferr* $(D_4)$ for stage 4.

In an alternative embodiment, all possible values for all possible error terms are computed and stored in a non-volatile memory array. The appropriate error term is selected using the bits of the output of the pipelined analog to digital converter as addresses. While this requires a large number of initial computations and a large amount of hardware non-volatile memory space, it results in faster corrected output as only one addition operation per error term is required.

As will be recognized by those skilled in the art, the innovative concepts described in the present application can be modified and varied over a tremendous range of applications, and accordingly the scope of patented subject matter is not limited by any of the specific exemplary teachings given.

For example, the piecewise approximation approach described for correction of amplifier gain and non-linearity errors can be applied to correct for capacitor non-linearity errors as well. Capacitor non-linearity is extremely difficult to determine and is usually measured, if at all, at manufacture time or derived from a device model. Once a capacitor's non-linearity has been determined over a given number of segments, $x_{ij}$, a look-up table, like the array 604 used to store the values for $\beta_{ij}$ and $\gamma_{ij}$, can be referenced to provide $\bullet_i$ values for the determination of $\beta_i$ and $\gamma_i$.

For another example, capacitor mismatch and amplifier gain errors are usually of such a minute degree that they do not manifest themselves until resolutions of more than 8 bits are attempted. Thus, for a 14-bit converter, preferably 6 bits or stages of the pipeline are corrected. However, a greater or fewer number of bits or stages can alternatively be corrected using this technique.

For another example, amplifier non-linearity errors typically do not manifest themselves until resolutions of more than 11 or 12 bits are attempted. Thus, for a 14-bit converter, 3 or more stages of the pipeline must be corrected. However, a greater or fewer number of bits or stages could be corrected using this technique.

For another example, a 1-bit per stage converter can also make use of this self-calibration technique.

For another example, other analog to digital conversion architectures, such as one-stage recycling converters can also make use of this self-calibration technique.

For another example, the digital self-correction technique described can be used in combination with analog self-correction techniques.

Further details of the system context and of options for implementation may be found in Michael J. Demler, HIGH-SPEED ANALOG-TO-DIGITAL CONVERSION (1991); Analog Devices, Inc., ANALOG-DIGITAL CONVERSION HANDBOOK (1986) ; and Behzad Razavi, PRINCIPLES OF DATA CONVERSION SYSTEM DESIGN (1995); IEEE Journal of Solid-State Circuits April 1994, A 12-B 600 KS/S DIGITALLY SELF-CALIBRATED PIPELINED ALGORITHMIC ADC 509; IEEE Journal of Solid-State Circuits February 1990 FULLY DIFFERENTIAL ADC WITH RAIL-TO-RAIL COMMON-MODE RANGE AND NONLINEAR CAPACITOR COMPENSATION 173; IEEE Journal of Solid-State Circuits April 1993 A LOW-POWER 12-B ANALOG-TO DIGITAL CONVERTER WITH ON-CHIP PRECISION TRIMMING 455; and IEEE Journal of Solid-State Circuits December 1990 ERROR CORRECTION TECHNIQUES FOR HIGH-PERFORMANCE DIFFERENTIAL A/D CONVERTERS 1318; all of which are hereby incorporated by reference.

## Claims

1. A method for converting analog signals to digital signals, comprising:

   digitizing an analog signal; and
   correcting said digitized signal with error terms which include components compensating for errors in two or more of the following:
   capacitor mismatch ratio;
   capacitor non-linearity;
   amplifier gain; and
   amplifier non-linearity.

2. The method of Claim 1 further comprising:
   performing said digitizing steps with a pipelined converter.

3. The method of Claim 1 or Claim 2 further comprising:
   correcting capacitor mismatch error for the most significant bit stages, but not for at least one of the least significant bit stages.

4. The method of any preceding claim further comprising:
   correcting amplifier gain and amplifier non-linearity error for the most significant bit stages, but not for at least one of the least significant bit stages.

5. The method of any preceding claim further comprising:

storing said error terms in a non-volatile random access memory.

6. The method of any preceding claim, wherein said step of digitizing said analog signal comprises:
measuring multiple ones of said capacitor mismatch ratio, capacitor non-linearity, amplifier gain, and amplifier non-linearity for each stage of a converter.

7. The method of Claim 6, wherein said step of measuring said amplifier gain and said amplifier non-linearity error ring, comprise the steps of:

dividing an input voltage range to an operational amplifier into a plurality of segments;
measuring amplifier gain and non-linearity error present for each segment of said input voltage; and
using the result obtained to calculate capacitor and amplifier error elements of said voltage segment.

8. The method of Claim 7, wherein the step of dividing an input voltage range into a plurality of segments comprises:
dividing an input voltage range into at least two segments for the most significant bit stages, and wherein at least one segment of the least significant bit stages is not measured.

9. The method of Claim 7 or Claims 8, wherein the step of dividing an input voltage range into a plurality of segments comprises:
dividing said input voltage range into at least one segment for at least one stage.

10. The method of any of Claims 7 to 9, wherein the step of dividing an input voltage range into a plurality of segments is achieved using a resistor network.

11. A method for converting analog signals to digital signals, comprising:

for each stage in said converter:

measuring capacitor mismatch ratio;
measuring amplifier gain and non-linearity error;
using the results obtained in steps measuring capacitor mismatch ratio and amplifier gain and non-linearity error to calculate capacitor and amplifier error elements; and
storing said capacitor and amplifier error elements;

referencing said capacitor and amplifier error elements for a given input signal value to produce an error value for each stage;
multiplying said error value for each stage by the result of step;
referencing said capacitor and amplifier error elements;
respectively summing the results of said multiplying step to produce total error; and
subtracting said total error from the digital output of said converter.

12. The method of Claim 11 further comprising:
performing said measuring and storing step with a pipelined converter.

13. The method of Claim 11 or Claim 12 further comprising:
measuring capacitor mismatch error is measured for the most significant bit stages, but not for at least one of the least significant bit stages.

14. The method of any of Claims 11 to 13 further comprising:
measuring amplifier gain and non-linearity error for the most significant bit stages, but not for at least one of the least significant bit stages.

15. The method of any of Claims 11 to 14 further comprising: storing said error elements in a non-volatile random access memory.

16. The method of any of Claims 11 to 15, wherein the step of measuring amplifier gain and non-linearity error comprises the steps of:

dividing an input voltage range to an operational amplifier into a plurality of segments;
measuring amplifier gain and non-linearity error present for each segment of said input voltage; and
using the result obtained to calculate capacitor and amplifier error elements of said voltage segment.

17. The method of Claim 16, wherein the step of dividing the input voltage range into a plurality of segments comprises:
dividing the input voltage range into at least two segments for the most significant bit stages, and wherein at least one segment of the least significant bit stages is not measured.

18. The method of Claim 16, wherein the step of dividing the input voltage range into a plurality of segments comprises:
dividing the input voltage range into at least two segments for the most significant bit stages, one segment for at least one stage, and wherein at least one segment of the least significant bit stages is not measured.

19. The method of any of Claims 16 to 18, wherein the step of dividing the input voltage range into a plurality of segments is achieved using a resistor network.

20. A method for converting analog signals to digital signals comprising:

for each stage in a converter:
measuring amplifier gain and non-linearity error;
using the results obtained in the step of measuring amplifier gain and non-linearity error to calculate amplifier gain and non-linearity elements; and
storing said amplifier gain and non-linearity error elements;
referencing said amplifier gain and non-linearity error elements for a given input signal value to produce an error value for each stage;
multiplying said error value for each stage by the result of the step of referencing said amplifier gain and non-linearity elements;
respectively summing the results of the step multiplying said error value to produce a total error; and
subtracting said total error from the digital output of said converter.

21. The method of Claim 20 further comprising:
performing said measuring referencing and multiplying steps with a pipelined converter.

22. The method of Claim 20 or Claim 21 further comprising:
measuring said amplifier gain and non-linearity error is for the most significant bit stages, but not for at least one of the least significant bit stages.

23. The method of any of Claims 20 to 22 further comprising:
storing said amplifier gain and non-linearity error elements in a non-volatile random access memory.

24. The method of any of Claim 20 to 23, wherein the step of measuring said amplifier gain and non-linearity error comprises the steps of:

dividing an input voltage range to an operational amplifier into a plurality of segments;
measuring amplifier gain and non-linearity error present for each segment of said input voltage; and
using the result obtained to calculate amplifier gain and non-linearity error elements of said voltage segment.

25. The method of Claim 24, wherein the step of dividing the input voltage range into a plurality of segments comprises:
dividing the input voltage range into at least two for the most significant bit stages, and wherein at least one of the least significant bit stages is not measured.

26. The method of Claim 24 or Claim 25, wherein the step of dividing the input voltage range into a plurality of segments comprises:
dividing the input voltage range into one segment for at least one stage.

27. The method of any of Claims 24 to 26, wherein the step of dividing said input voltage range into a plurality of segments is achieved using a resistor network.

28. A system of analog to digital conversion comprising:

an analog to digital converter with a plurality of stages;

a first stage of said plurality of stages having an analog input and an analog output and a digital output;

successive stages having an analog and a digital input and an analog and a digital output;

a non-volatile memory array for storing data corresponding to capacitor and amplifier error of each said stage of said converter; and

digital logic for referencing said capacitor and amplifier error elements to produce an error value for a given input signal value for each stage;

multiplying said error value for each stage by the error value;

respectively summing the results of multiplying said error value to produce total error; and

subtracting said total error from the digital output of said converter.

29. The system of Claim 28, wherein only amplifier gain and non-linearity errors are stored and referenced.

30. The system of Claim 28 or Claim 29, wherein said converter is a pipelined converter.

31. The system of any of Claims 28 to 30, wherein said amplifier gain and non-linearity error is referenced and stored for the most significant bit stages but not for at least one of the least significant bit stage.

32. The system of any of Claims 28 to 31, wherein said error value is produced for the most significant bit stages, but not for at least one of the least significant bit stages.

FIG. 1

FIG. 2A

FIG. 2B

FIG. 3

$C_2$

$C_1$

$V_{in}(i)$

$D_i V_R$

$V_o(i)$

406

414

416

*FIG. 4*
*(PRIOR ART)*

ALTERNATIVELY

502

$V_x$

504

512

$\frac{2}{A_i} V_x$

DIGITIZE

$\div$

$\frac{1}{A_1}$

$V_x$

DIGITIZE

510

*FIG. 5*

710

716

DIGITAL LOGIC

$V_{in}$

$D_1$

$D_2$

$D_i$

$D_{i+1}$

1

$V_{in}(2)$

2

i

$V_o(1)$

$V_{in}(i)$

$V_o(i)$

702

704

704

704

*FIG. 7*

14

*FIG. 6*